# EUROPÄISCHE PATENTSCHRIFT

(11) **EP 1 310 040 B1**
(45) Veröffentlichungstag und Bekanntmachung des Hinweises auf die Patenterteilung: **25.10.2006**
(21) Anmeldenummer: 01969241.7
(22) Anmeldetag: 16.08.2001
(51) Int. Cl.: H03F 1/52

(54) **SCHALTUNGSANORDNUNG ZUR ERKENNUNG EINES FEHLERZUSTANDS**
CIRCUIT CONFIGURATION FOR IDENTIFYING A FAULTY STATE
CIRCUITERIE POUR LA DETECTION D'UN ETAT D'ERREUR

(30) Priorität: 16.08.2000 DE 10040092
(43) Veröffentlichungstag der Anmeldung: 14.05.2003
(73) Patentinhaber: Infineon Technologies AG, 81669 München (DE)
(72) Erfinder: AUSSERLECHNER, Udo, A-9500 Villach (AT); BODENSTORFER, Ernst, A-2345 Brunn Am Gebirge (AT)
(74) Vertreter: Epping - Hermann - Fischer
(86) Internationale Anmeldenummer: PCT/DE2001/003118
(87) Internationale Veröffentlichungsnummer: WO 2002/015392

(56) Entgegenhaltungen:
- DE-A- 2 833 501
- US-A- 3 988 695
- US-A- 4 678 950
- US-A- 4 691 129

## Beschreibung

Die vorliegende Erfindung betrifft eine Schaltungsanordnung zur Erkennung eines Fehlerzustands.

Aus Gründen der Betriebssicherheit ist es beispielsweise in Kraftfahrzeugen häufig erforderlich, integrierte Schaltkreise, an denen über lange Leitungen elektrische Lasten anschließbar sind, mit einer Fehlerzustandserkennung zu versehen. Ein derartiger Fehlerzustand kann beispielsweise bei einer Unterbrechung einer Versorgungsleitung gegeben sein.

Es kann beispielsweise wünschenswert sein, den ausgangsseitigen Anschluß einer linearen Ausgangsstufe bei Bruch oder Unterbrechung einer von zumindest zwei Versorgungsleitungen mit der jeweils anderen, intakten Versorgungsleitung niederohmig zu verbinden. In einem Normalbetriebszustand muß jedoch zwischen Ausgangsanschluß der Schaltungsanordnung und den Versorgungspotentialanschlüssen eine hochohmige Verbindung bestehen, um hohe Verlustleistungen der Schaltung zu vermeiden. Zudem muß bei Auftreten eines Fehlerzustands der Übergang von einer hochohmigen zu einer niederohmigen Verbindung sehr schnell erfolgen. Schließlich dürfen wegen zusätzlicher Schaltungsmaßnahmen keine unerwünschten Rückwirkungen auf die Nutzsignale oder die Versorgungsspannung auftreten.

Das beschriebene Problem könnte mit einer Hochvolt-CMOS-Technologie gelöst werden. Dies würde jedoch einen zusätzlichen Aufwand bedeuten.

Dokument US-A-4,691,129 ist eine Treiberschaltung für einen Leistungsfeldeffekttransistor mit einer quellenseitigen Last zu entnehmen. Damit werden Überlastungen des Leistungstransistors vermieden.

Aufgabe der vorliegenden Erfindung ist es, eine Schaltungsanordnung zur Erkennung eines Fehlerzustands anzugeben, welche eine geringe Verlustleistung aufweist, eine geringe Ansprechzeit hat und für große Versorgungsspannungen geeignet ist.

Erfindungsgemäß wird die Aufgabe mit einer Schaltungsanordnung zur Erkennung eines Fehlerzustands gelöst, mit
- drei Anschlüssen, umfassend einen ersten Schaltungsknoten, an den eine elektrische Last anschließbar ist, einen Anschluß für ein Versorgungspotential und einen Anschluß für ein Bezugspotential, welche an eine Spannungsquelle anschließbar sind,
- einer signalverarbeitenden Schaltung, deren Ausgang an den ersten Schaltungsknoten angeschlossen ist,
- einem ersten Transistor, der von einem selbstleitenden Typ ist,
- der einen ersten Lastanschluß hat, welcher mit dem ersten Schaltungsknoten verbunden ist,
- der einen zweiten Lastanschluß hat, welcher mit dem Anschluß für Versorgungspotential oder Bezugspotential verbunden ist,
- wobei in einem Normalbetriebszustand am Steuereingang des ersten Transistors eine dessen Kanal abschnürende Spannung anliegt und in einem Fehlerzustand der erste und der zweite Lastanschluß des Transistors niederohmig über dessen Kanal verbunden sind.

Selbstleitende Transistoren sind auch als Transistoren von einem Verarmungstyp (Depletion Type) bekannt. Zum Abschnüren des Kanals in einem Normalbetriebszustand kann eine Gatespannung des ersten Transistors entweder über ein positives Versorgungspotential oder unter ein negatives Versorgungspotential gepumpt werden, wodurch eine Entkopplung der Schaltungsknoten gewährleistet ist. In einem Fehlerfall wird diese Verbindung niederohmig, so daß der Transistor aufgrund seiner Beschaltung als nichtlinearer Widerstand wirkt.

In der Schaltungsanordnung können zur Bereitstellung von den Kanal abschnürenden Spannungen Ladungspumpen vorgesehen sein, welche eine entsprechende Steuerspannung, welche außerhalb der Versorgungsspannung der Schaltungsanordnung liegt, bereitstellen. In einem Fehlerfall, beispielsweise bei Unterbrechung der Versorgungsspannung, an die die Ladungspumpen zu ihrer Versorgung angeschlossen sind, bricht die Steuerspannung ein, wodurch der Kanal nicht mehr abgeschnürt ist, der Transistor leitend wird und den ersten Schaltungsknoten niederohmig mit dem Bezugs- oder Versorgungspotentialanschluß verbindet.

In einer vorteilhaften Ausführungsform der vorliegenden Erfindung ist der Fehlerzustand dann gegeben, wenn eine an die Schaltungsanordnung angeschlossene Versorgungsleitung, welche die Spannungsquelle mit Versorgungs- oder Bezugspotentialanschluß verbindet, unterbrochen ist oder eine unter einer minimalen Spannungsgrenze liegende Spannung aufweist. Die an die Schaltungsanordnung angeschlossene Versorgungsleitung kann dabei lang sein und zwischen der Schaltungsanordnung und einer unmittelbar mit der Spannungsquelle verbundenen elektrischen Last angeordnet sein.

In einer weiteren, vorteilhaften Ausführungsform der vorliegenden Erfindung ist die signalverarbeitende Schaltung eine lineare Ausgangsstufe. Bei linearen Ausgangsstufen kann es aus Gründen der Betriebssicherheit vorteilhaft sein, bei Bruch einer Versorgungsleitung das Ausgangspin der Ausgangsstufe niederohmig mit der übrig bleibenden, intakten Versorgungsleitung zu verbinden.

In diesem Fall kann ein Fehlerzustand beispielsweise dadurch leicht detektiert werden, daß eine lineare Ausgangsstufe einen Aussteuerbereich hat, welcher in einem Spannungsintervall liegt, welches kleiner als die Versorgungsspannung ist, so daß durch Festlegen des Ausgangspotentials auf ein Versorgungspotential, welches nicht vom Aussteuerbereich umfaßt wird, in einfacher Weise eine Fehlerzustandserkennung möglich ist. Beispielsweise kann die lineare Ausgangsstufe einen Aussteuerbereich haben, welcher von 1 Volt bis 4 Volt reicht. Wenn nun das Ausgangspotential beispielsweise kleiner 0,5 Volt oder größer 4,5 Volt beträgt und demnach nahe am Bezugspotential oder nahe am Versorgungspotential liegt, so ist dadurch ein Fehlerzustand in einfacher Weise detektierbar.

In einer weiteren, vorteilhaften Ausführungsform der vorliegenden Erfindung ist der zweite Lastanschluß des ersten Transistors an einen Versorgungspotentialanschluß angeschlossen und eine elektrische Last in einem ersten Lastfall einerseits an den ersten Schaltungsknoten und andererseits an ein Bezugspotential angeschlossen. Ein Fehlerzustand ist in diesem Fall dann gegeben, wenn die das Bezugspotential führende Versorgungsleitung unterbrochen ist und der erste Transistor in diesem Fall eine niederohmige Verbindung zwischen Versorgungspotential und erstem Schaltungsknoten herstellt. Dabei kann eine Spannungsquelle zwischen Versorgungs- und Bezugspotential vorgesehen sein, welche lastseitig an der elektrischen Last angeschlossen sein kann. In einem zweiten Lastfall kann die elektrische Last zwischen erstem Schaltungsknoten und Versorgungspotential angeordnet sein, so daß bei Unterbrechung der das Versorgungspotential führenden Versorgungsleitung eine niederohmige Verbindung zwischen erstem Schaltungsknoten und Bezugspotential herzustellen ist.

Die elektrische Last kann eine rein ohmsche Last sein.

In einer weiteren, vorteilhaften Ausführungsform der vorliegenden Erfindung ist ein zweiter Transistor vorgesehen, der einen ersten Lastanschluß hat, welcher an das Bezugspotential angeschlossen ist und der einen zweiten Lastanschluß hat, welcher mit dem ersten Schaltungsknoten verbunden ist, wobei in einem Normalbetrieb am Steuereingang des zweiten Transistors eine dessen Kanal abschnürende Spannung anliegt.

Das Vorsehen eines zweiten Transistors in der Schaltungsanordnung hat den Vorteil, daß je ein Transistor zwischen erstem Schaltungsknoten und je einem Bezugs- bzw. Versorgungspotential vorgesehen ist, so daß ein Fehlerzustand unabhängig davon erkennbar ist, ob die elektrische Last zwischen erstem Schaltungsknoten und Versorgungspotential oder zwischen erstem Schaltungsknoten und Bezugspotential angeordnet ist.

In einer weiteren, vorteilhaften Ausführungsform der vorliegenden Erfindung sind der erste und der zweite Transistor P-Kanal-JFETs. P-Kanal-Sperrschicht-Feldeffekt-Transistoren (Junction-FET) haben den Vorteil, daß diese verpolungsfest sind, das heißt, daß das Versorgungspotential gegenüber dem Bezugspotential negativ werden darf, ohne daß dabei ein unzulässig großer Strom fließt.

In einer weiteren, vorteilhaften Ausführungsform der vorliegenden Erfindung sind der erste und der zweite Transistor N-Kanal-JFETs.

In einer weiteren, vorteilhaften Ausführungsform der vorliegenden Erfindung ist ein dritter Transistor vorgesehen, der lastseitig einerseits an das Versorgungspotential und andererseits an den ersten Transistor angeschlossen ist, und ein vierter Transistor vorgesehen, der lastseitig einerseits an den zweiten Transistor und andererseits an das Bezugspotential angeschlossen ist. Das Vorsehen mehrerer, seriell geschalteter Transistoren zwischen je einem ersten und einem zweiten Schaltungsknoten hat den Vorteil, daß die Schaltungsanordnung selbst für hohe angelegte Spannungen geeignet ist. Dabei genügt es, wenn von mehreren, zwischen erstem und zweitem Schaltungsknoten seriell lastseitig miteinander verbundenen Transistoren zumindest einer mit einer Gatespannung betrieben wird, welche außerhalb der Versorgungsspannung liegt, das heißt betragsmäßig größer ist.

In einer weiteren, vorteilhaften Ausführungsform der vorliegenden Erfindung ist eine Teilschaltung zur Begrenzung der Verlustleistung vorgesehen, welche an die Steuereingänge des ersten, zweiten, dritten und vierten Transistors angeschlossen ist. Die Teilschaltung zur Begrenzung der Verlustleistung ermöglicht einen Betrieb der Transistoren als nichtlineare Widerstände unabhängig von der Polarität der angelegten Spannung.

Bei einer weiteren, vorteilhaften Ausführungsform der vorliegenden Erfindung, welche eine mögliche Ausführung der Teilschaltung realisiert, ist
- ein erster Widerstand zwischen versorgungspotential und einem Lastanschluß des dritten Transistors angeschlossen,
- ein zweiter Widerstand zwischen erstem Schaltungsknoten und erstem Lastanschluß des ersten Transistors und
- ein dritter Widerstand zwischen erstem Schaltungsknoten und zweitem Lastanschluß des zweiten Transistors angeschlossen,
- ein vierter Widerstand parallel zu einer ersten Diode zwischen Versorgungspotential und einem Steuereingang des dritten Transistors angeschlossen, an dem eine zweite Diode seriell zu einem fünften Widerstand gegen den ersten Schaltungsknoten geschaltet ist,
- ein sechster Widerstand einerseits an den ersten Schaltungsknoten und andererseits an den Steuereingang des vierten Transistors angeschlossen,
- eine dritte Diode und eine vierte Diode einerseits an den ersten Schaltungsknoten und andererseits an je einen Steuereingang des ersten bzw. zweiten Transistors angeschlossen und
- eine fünfte Diode einerseits mit dem Versorgungspotential und andererseits mit einem siebten Widerstand verbunden, welcher an den Steuereingang des ersten Transistors angeschlossen ist.

Die beschriebene Beschaltung der Transistoren weist zum einen dadurch eine geringe Verlustleistung auf, daß die Transistoren bei höheren Spannungen höherohmig werden, was selbst dann noch gilt, wenn die Transistoren bereits im Durchbruch betrieben werden. Zudem wird die Leistungsaufnahme der Schaltung selbst dann begrenzt, wenn die am ersten Schaltungsknoten abgreifbare Spannung höher als das Versorgungspotential ist, indem mittels der vierten Diode der Steuereingang des ersten Transistors auf das Potential des ersten Schaltungsknotens hochgezogen wird, während ein mit viertem und fünftem Widerstand gebildeter Spannungsteiler am Steuereingang des dritten Transistors ein Potential einstellt, welches erst bei sehr hohen Spannungen zwischen erstem Schaltungsknoten und Bezugspotential zu einem Durchbrechen des dritten Transistors führt.

In einer weiteren, vorteilhaften Ausführungsform der vorliegenden Erfindung sind Gate-Entladewiderstände vorgesehen, von denen ein erster einerseits an den Steueranschluß des ersten und andererseits an den Steueranschluß des zweiten Transistors angeschlossen ist und ein zweiter Gate-Entladewiderstand einerseits an den Steuereingang des ersten Transistors und andererseits an das Versorgungspotential angeschlossen ist. Hierdurch ergibt sich zum einen eine geringe Belastung einer im Normalbetrieb das Potential für die Steuereingänge von erstem und zweitem Transistor bereitstellenden Ladungspumpe sowie durch die Entkopplung von erstem und zweitem Steuereingang selbst bei Durchbrechen von erstem oder zweitem Transistor eine geringe elektrische Belastung der Ladungspumpe.

In einer weiteren, vorteilhaften Ausführungsform der vorliegenden Erfindung sind Glättungskondensatoren vorgesehen, von denen ein erster zwischen zweitem Lastanschluß des ersten Transistors und Steuereingang des ersten Transistors und ein zweiter zwischen Steuereingang des zweiten Transistors und zweitem Lastanschluß des ersten Transistors angeschlossen ist. Diese Anordnung der Glättungskondensatoren vermeidet eine hohe Belastung der Glättungskondensatoren durch hohe, an den Steuereingängen anliegende Spannungen, sowie einen Schutz vor elektromagnetisch oder elektrostatisch eingekoppelten Impulsen, und verhindert ein Übergreifen der Kondensator-Entladeströme auf den ersten Schaltungsknoten.

In einer weiteren, vorteilhaften Ausführungsform der vorliegenden Erfindung ist ein zweiter Transistor lastseitig zwischen Versorgungs- und Bezugspotential angeschlossen. Dadurch wird insbesondere bei versorgungspotentialseitig angeschlossenem Lastwiderstand und bei Vorsehen einer linearen Ausgangsstufe ein monotones Einschaltverhalten des Potentials am ersten Schaltungsknoten, dem Ausgang der Ausgangsstufe, erreicht, da kein Transistor zwischen erstem Schaltungsknoten und Versorgungspotential erforderlich ist. Außerdem weist die Ausführungsform verbesserte Überspannungseigenschaften sowie verminderte Störrippel auf.

Weitere Einzelheiten der Erfindung sind in den Unteransprüchen angegeben.

Die Erfindung wird nachfolgend an mehreren Ausführungsbeispielen anhand der Zeichnungen näher erläutert. Es zeigen:
- Figur 1: ein Ausführungsbeispiel der vorliegenden Erfindung anhand eines Blockschaltbilds,
- Figur 2: die Schaltung von Figur 1, angewandt auf einen zweiten Lastfall,
- Figur 3: eine unabhängig vom Lastfall gemäß Figur 1 und 2 realisierte Schaltungsanordnung,
- Figur 4: eine Weiterbildung der Schaltungsanordnung IC3 aus Figur 3,
- Figur 5: ein weiteres Ausführungsbeispiel der vorliegenden Erfindung anhand eines Blockschaltbilds und
- Figur 6: die Schaltung gemäß Figur 5, angewandt auf den zweiten Lastfall.

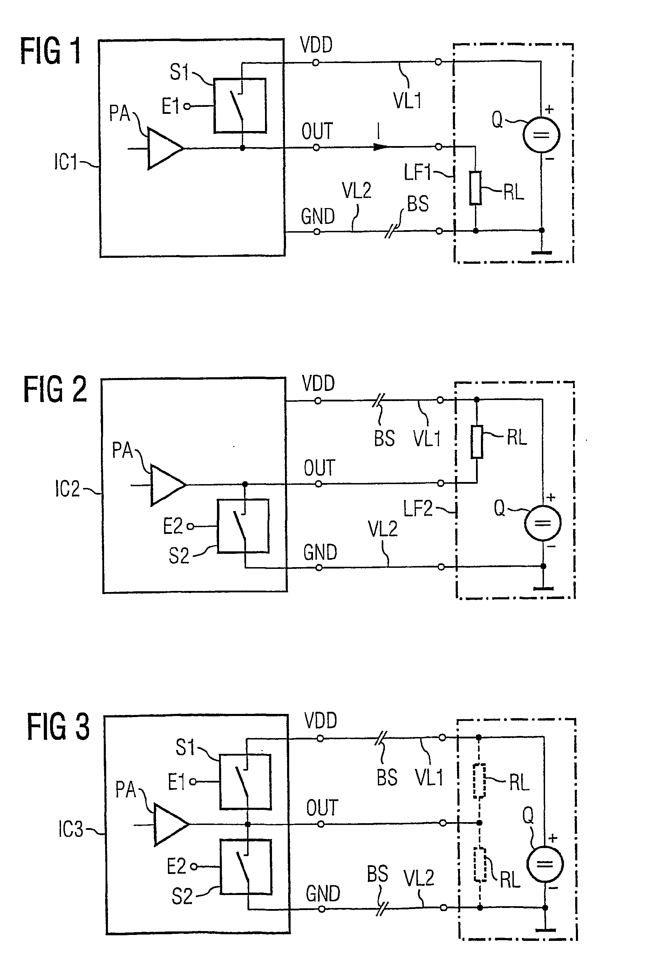

Figur 1 zeigt eine erste Ausführungsform der Schaltungsanordnung IC1 mit einer linearen Ausgangsstufe PA, welche einen Ausgang OUT hat, an den ein erster, zur Vereinfachung als Schalter dargestellter Transistor S1 lastseitig angeschlossen ist. Der erste Transistor S1 weist einen Steuereingang E1 auf und ist lastseitig andererseits an ein Versorgungspotential VDD angeschlossen. Die Schaltungsanordnung IC1 ist zudem an ein Bezugspotential GND angeschlossen. Weiterhin ist eine elektrische Last RL vorgesehen, welche in einem ersten Lastfall LF1 als sogenannter Pull-Down-Lastwiderstand an den Ausgang OUT sowie an das Bezugspotential GND über Leitungen, welche lang sein können, angeschlossen ist. An die elektrische Last RL ist bezugspotentialseitig eine Spannungsquelle Q angeschlossen, welche mit ihrem Plus-Pol an das Versorgungspotential VDD angeschlossen ist. Zum Führen des Versorgungs- und Bezugspotentials VDD, GND sind Versorgungsleitungen VL1, VL2 vorgesehen. Wenn in einem Fehlerfall die Versorgungsleitung VL2 eine Bruchstelle BS aufweist, das heißt einen Massebruch, so schaltet der erste Transistor S1 den Ausgang OUT der Ausgangsstufe PA auf das Versorgungspotential VDD. Hierdurch ist zum einen die Schaltung geschützt und zum anderen kann der durch Bruch BS der Masseleitung VL2 gegebene Fehlerfall erkannt werden.

Figur 2 zeigt einen zweiten Lastfall LF2, bei dem der Lastwiderstand RL als sog. Pull-Up-Last realisiert ist, welche einerseits an dem Ausgang OUT der linearen Verstärkerstufe PA und andererseits mittels einer Versorgungsleitung VL1 an ein Versorgungspotential VDD angeschlossen ist. Zwischen Versorgungs- und Bezugspotential VDD, GND ist, wie in Figur 1, eine Spannungsquelle Q vorgesehen, welche an die elektrische Last RL angeschlossen ist. In diesem Fall könnte vom Auftreten einer Bruchstelle BS in der das Versorgungspotential VDD führenden Versorgungsleitung VL1 eine Gefahr für die Betriebssicherheit ausgehen, so daß in diesem Fall ein zweiter Transistor S2 vorgesehen ist, der lastseitig einerseits mit dem Ausgang OUT und andererseits mit dem Bezugspotential GND verbunden ist und einen zweiten Steuereingang E2 aufweist. Bei Auftreten eines Fehlers, beispielsweise durch Auftreten einer Bruchstelle BS, stellt der zweite Transistor S2 eine niederohmige Verbindung zwischen Ausgang des Verstärkers PA und Bezugspotential GND her.

Figur 3 zeigt eine Schaltungsanordnung IC3, welche eine Kombination der Schaltungsanordnungen IC1, IC2 der Figuren 1 und 2 darstellt. Dabei ist am Ausgang der linearen Ausgangsstufe PA zum einen ein erster Transistor S1 angeschlossen, der andererseits an ein Versorgungspotential VDD angeschlossen ist, und zum anderen ein zweiter Transistor S2 angeschlossen, der andererseits mit einem Bezugspotential GND verbunden ist. Erster und zweiter Transistor S1, S2 weisen jeweils einen Steuereingang E1, E2 auf. Unabhängig davon, ob an die Schaltungsanordnung IC3 eine elektrische Last RL gemäß eines in Figur 1 dargestellten, ersten Lastfalles LF1 oder gemäß eines in Figur 2 dargestellten, zweiten Lastfalles LF2 angeschlossen ist, ermöglicht es die Schaltungsanordnung IC3 gemäß Figur 3, bei Auftreten einer Bruchstelle in der ersten Versorgungsleitung VL1 oder der zweiten Versorgungsleitung VL2 den Ausgang OUT der linearen Verstärkerstufe PA mit dem Bezugspotential GND und/oder mit dem Versorgungspotential VDD niederohmig zu verbinden und so zum einen eine einfache Erkennung eines Fehlerzustands zu ermöglichen und zum anderen Folgeschäden durch den Bruch der Versorgungsleitungen VL1, VL2 zu vermeiden.

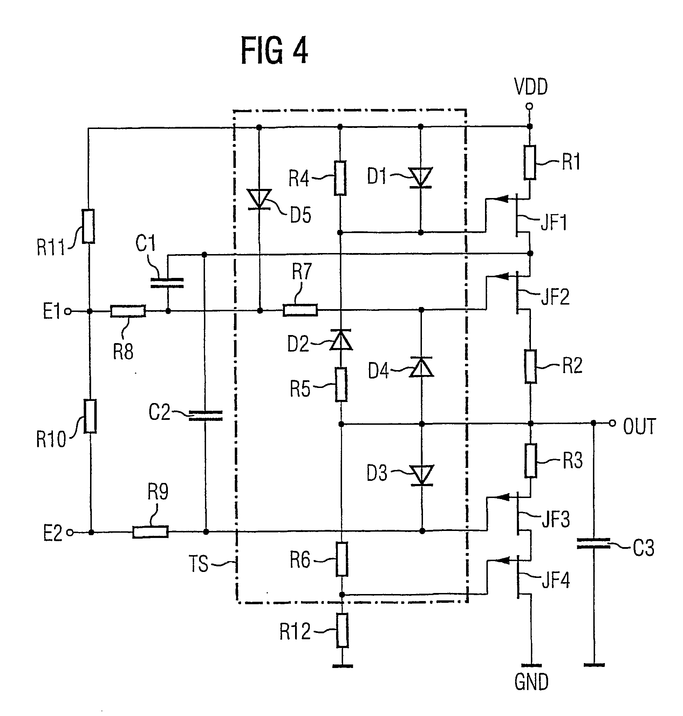

Figur 4 zeigt eine Weiterbildung der Schaltungsanordnung IC3 von Figur 3. Die Schaltung gemäß Figur 4 weist zwei Steuereingänge E1, E2 zur Steuerung des ersten Transistors JF2 bzw. des zweiten Transistors JF3 auf. Zudem ist ein Ausgang OUT vorgesehen, an dem beispielsweise der Ausgang einer linearen Ausgangsstufe anschließbar ist, sowie Anschlüsse für Versorgungs- und Bezugspotential VDD, GND.

Lastseitig in Serie zu erstem und zweitem Transistor JF2, JF3 ist jeweils ein dritter bzw. vierter Transistor JF1, JF4 angeordnet. Der erste bis vierte Transistor ist als P-Kanal-JFET realisiert. Zwischen dem Ausgang OUT, der den ersten Schaltungsknoten der Schaltung darstellt, und Versorgungs- und Bezugspotential VDD, GND sind je zwei Transistoren lastseitig in Serie geschaltet, von denen je einer durch einen Steuereingang E1, E2 steuerbar ist. Dabei ist der Source-Anschluß des dritten Transistors JF1 über einen ersten Widerstand R1 an das Versorgungspotential VDD angeschlossen. Der Drain-Anschluß des dritten Transistors JF1 ist mit dem Source-Anschluß des ersten Transistors JF2 verbunden. Der Drain-Anschluß des ersten Transistors JF2 ist über einen zweiten Widerstand R2 an den Ausgang OUT angeschlossen. Der Source-Anschluß des zweiten Transistors JF3 ist über einen dritten Widerstand R3 ebenfalls an den Ausgang OUT angeschlossen. Der Drain-Anschluß des zweiten Transistors JF3 ist an den Source-Anschluß des vierten Transistors JF4 angeschlossen, dessen Drain-Anschluß mit dem Bezugspotential GND verbunden ist. An die Steuereingänge E1, E2 des ersten bzw. zweiten Transistors JF2, JF3 ist in einem Normalbetrieb ein Potential angelegt, welches jeweils den Kanal der selbstleitenden Transistoren JF2, JF3 abschnürt. An die Steuereingänge der vier Transistoren JF1 bis JF4 ist eine Teilschaltung TS aus mehreren Dioden D1 bis D5 sowie mehreren Widerständen R1 bis R7 angeschlossen, welche die Begrenzung der Verlustleistung bei hohen Betriebsspannungen realisiert.

Im Einzelnen ist dabei mit einer ersten Diode D1 und einem vierten Widerstand R4, welche zueinander parallel geschaltet sind und einerseits jeweils an den Versorgungspotential-Anschluß VDD und andererseits an das Gate des dritten Transistors JF1 angeschlossen sind, eine Schaltung realisiert, welche, wenn das Bezugspotential VDD groß gegenüber dem am Ausgang OUT anliegenden Potential ist, das Gate des dritten Transistors JF1 auf Versorgungspotential VDD hält, während der über den ersten Widerstand R1 fließende Strom das Potential am Source-Anschluß unter das am Gate-Anschluß des dritten Transistors JF1 drückt, wodurch der Kanal des dritten Transistors JF1 mit zunehmendem Drain-Strom hochohmiger wird.

Eine fünfte Diode D5, welche einerseits an das Versorgungspotential VDD und andererseits an einen siebten Widerstand R7, der mit dem Gate des ersten Transistors JF2 verbunden ist, angeschlossen ist, bewirkt gemeinsam mit diesem, daß, wenn das Versorgungspotential VDD groß gegenüber dem Potential am Ausgang OUT ist, das Gate des ersten Transistors JF2 auf Versorgungspotential VDD gehalten wird, während der über R1 und den Kanal des ersten Transistors JF2 fließende Strom bewirkt, daß der Source-Anschluß des ersten Transistors JF2 unter das Potential des Gate-Anschluß desselben gedrückt wird, so daß auch der Kanal des ersten Transistors JF2, ebenso wie der des dritten Transistors JF1, mit zunehmendem Drain-Strom hochohmiger wird. Der siebte Widerstand R7 begrenzt dabei, falls das Gate des ersten Transistors JF2 bei zu hohen Versorgungspotentialen VDD durchbricht, den Strom auf genügend kleine Werte, so daß eine zu starke Degradation des Gates des ersten Transistors JF2 vermieden werden kann.

Eine dritte Diode D3 ist einerseits am Ausgang OUT und andererseits am Gate des zweiten Transistors JF3 angeschlossen. Diese bewirkt, daß bei einem großen Spannungsunterschied zwischen Ausgang OUT und Bezugspotential GND der Gate-Anschluß des zweiten Transistors JF3 auf dem Potential am Ausgang OUT gehalten wird, während über dem dritten Widerstand R3 ein Stromfluß resultiert, welcher bewirkt, daß der Source-Anschluß potentialmäßig unter das Gate-Potential des zweiten Transistors JF3 gedrückt wird, so daß wiederum der Kanal des zweiten Transistors JF3 mit zunehmendem Drain-Strom hochohmiger wird.

Mit einem sechsten Widerstand R6, der einerseits an den Ausgang OUT und andererseits an das Gate des vierten Transistors JF4 angeschlossen ist, wird bei einer Spannungsüberhöhung am Ausgang OUT gegenüber Bezugspotential GND das Gate des vierten Transistors JF4 auf dem am Ausgang OUT anliegenden Potential gehalten, während der Stromfluß durch dritten Widerstand R3 und zweiten Transistor JF3 bewirkt, daß der Source-Anschluß des vierten Transistors JF4 potentialmäßig unter die am Gate desselben anliegende Spannung gedrückt wird, so daß auch der Kanal des vierten Transistors JF4 mit zunehmendem Drain-Strom hochohmiger wird. Der Vorteil der Verwendung eines sechsten Widerstands R6 anstelle einer Diode hat den Vorteil, daß der Widerstand R6 bei einem Durchbruch der Gate-Drain-Strecke des vierten Transistors JF4 den Gate-Strom desselben beschränkt, um Degenerierung bzw. Degradation am vierten Transistor JF4 zu vermeiden.

Eine vierte Diode D4, welche einerseits an den Ausgang OUT und andererseits an den Gate-Anschluß des ersten Transistors JF2 angeschlossen ist, bewirkt bei Vorliegen einer Spannungsüberhöhung am Ausgang OUT gegenüber Versorgungspotential VDD, daß das Gate des ersten Transistors JF2 auf Ausgangspotential am Ausgang OUT gehalten wird, während sich über dem zweiten Widerstand R2 ein Stromfluß einstellt, welcher die Drain potentialmäßig unter das Gate des ersten Transistors JF2 drückt, so daß dessen Kanal mit zunehmendem Drain-Strom hochohmiger wird. Dabei werden elektrisch betrachtet die Funktionen von Drain und Source des ersten Transistors JF2 vertauscht.

Weiterhin ist an den Ausgang OUT ein fünfter Widerstand R5 angeschlossen, zu dem eine zweite Diode D2 in Serie geschaltet ist, welche am Gate-Anschluß des dritten Transistors JF1 angeschlossen ist. Diese Beschaltung der zweiten Diode D2 mit dem fünften Widerstand R5 bewirkt, daß bei Anliegen einer großen Potentialdifferenz des Ausgangs OUT gegenüber Versorgungspotential VDD das Gate-Potential auf Potential am Ausgang OUT gehalten wird, während durch zweiten Widerstand R2 und Kanal des ersten Transistors JF2 ein Strom fließt, welcher den Drain-Anschluß des dritten Transistors JF1 potentialmäßig unter den Gate-Anschluß des dritten Transistors JF1 drückt, so daß schließlich auch der Kanal des dritten Transistors JF1 mit zunehmendem Drain-Strom hochohmiger wird. Auch Drain und Source des dritten Transistors JF1 tauschen elektrisch betrachtet ihre Funktion. Der fünfte Widerstand R5 begrenzt für den Fall, daß die Gate-Source-Strecke des dritten Transistors JF1 durchbricht, den Gate-Strom.

Die beschriebene Teilschaltung TS zur Begrenzung der Verlustleistung, welche die erste bis fünfte Diode D1 bis D5 sowie ersten bis siebten Widerstand R1 bis R7 umfaßt, dient neben der beschriebenen Begrenzung der Verlustleistung bei hohen Betriebsspannungen auch zur Begrenzung der Verlustleistung bei negativer Betriebsspannung, das heißt im Verpolungsfall des Versorgungspotentials VDD. Wenn der Ausgang OUT zugleich Ausgang einer linearen Ausgangsstufe ist, so stellt sich am Ausgang OUT ein Potential ein, welches in einem Verpolungsfall wegen der linearen Ausgangsstufe oder einer üblicherweise nicht verpolungsgeschützten Diode zum Schutz vor elektrostatischen Entladungen am Ausgang unterhalb des Bezugspotentials GND liegt. Dies führt dazu, daß über ersten und zweiten Widerstand R1, R2 sowie lastseitig über ersten und dritten Transistor JF2, JF1 ein beträchtlicher Strom fließt, welcher lediglich durch die beschriebenen negativen Rückkopplungsschleifen, nämlich eine innere Schleife über vierte Diode D4, ersten Transistor JF2 und zweiten Widerstand R2 sowie eine äußere Rückkopplungsschleife über fünften Widerstand R5, zweite Diode D2, ersten und dritten Transistor JF2, JF1 sowie über zweiten Widerstand R2 begrenzt werden kann. In einem Verpolfall wäre der dritte Transistor JF1 hohen Gate-Source-Spannungen ausgesetzt, was dazu führen könnte, daß sein Gate-Kanal-Übergang degradiert, was nach und nach zu einem starken, unerwünschten Ansteigen seines Gate-Leckstromes führen könnte. Der Gate-Anschluß des dritten Transistors JF1 ist dabei nicht an den Steuereingang E1 angeschlossen, um eine daran angeschlossene Ladungspumpenschaltung nicht unzulässig elektrisch zu belasten. Der erste Transistor JF2 ist auch in einem Verpolfall wesentlich geringeren elektrischen Belastungen ausgesetzt, so daß hier die Gefahr einer Degradation nicht gegeben ist. Demnach darf dessen Gateanschluß über Schutz- und Glättungswiderstände R7, R8 an den Steuereingang E1 angeschlossen werden. In einem Verpolungsfall würde nämlich gemäß des Dotierungsprofils eines P-Kanal-JFETs die Gate-Substratdiode des P-JFETs in Flußrichtung gepolt sein und, wenn der Widerstandswert des ersten Widerstands R1 klein eingestellt ist, fast die gesamte, verpolte Spannung an der Gate-Source-Strecke des dritten Transistors JF1 abfallen, wobei das Gate-Potential am dritten Transistor JF1 ca. - 0,5 Volt und das Source-Potential am dritten Transistor JF1 ungefähr der Summe des Versorgungspotentials VDD plus dem Produkt aus erstem Widerstand R1 und Versorgungsstrom entspricht. Die Schaltung ist dabei für eine Verpolfestigkeit von - 18 Volt ausgelegt.

Zum schnellen Ansprechen der Schaltungsanordnung bei Auftreten eines Fehlerzustands sind ein zehnter Widerstand R10 und ein elfter Widerstand R11 vorgesehen. Der elfte Widerstand R11, welcher einerseits an das Versorgungspotential VDD und andererseits an den ersten Steuereingang E1 des ersten Transistors JF2 angeschlossen ist, dient dazu, daß sich bei Bruch oder Unterbrechung der das Bezugspotential GND tragenden Versorgungsleitung das Gate des ersten Transistors JF2 schnell entlädt. Um dennoch die Strombelastung einer Ladungspumpe, welche an Steuereingänge E1, E2 angeschlossen sein kann, gering zu halten, beträgt der Widerstandswert des elften Widerstands R11 mehrere Megaohm. Der über R11 auftretende Verluststrom beträgt demnach lediglich Abschnürspannung des Transistors geteilt durch Widerstandswert des elften Widerstands.

Falls ein Fehlerfall dadurch bedingt ist, daß die am Versorgungspotential VDD oder die am Bezugspotential GND angeschlossene Versorgungsleitung bricht oder unterbrochen ist, so ist das Gate des ersten und zweiten Transistors JF2, JF3 schnell zu entladen, wofür ein zehnter Widerstand R10 und der elfte Widerstand R11 vorgesehen sind. Der zehnte Widerstand R 10 ist dabei zwischen Steuereingang E1 des ersten Transistors und Steuereingang E2 des zweiten Transistors JF3 angeschlossen. Da in einem Normalbetriebszustand die Potentiale an den Steuereingängen E1, E2 gleich sind, belastet der zehnte Widerstand R10 eine angeschlossene Ladungspumpe nicht. Dennoch beträgt der Widerstandswert des zehnten Widerstands R10 einige Megaohm, damit im Falle eines Durchbruchs des zweiten Transistors JF3 der erste Transistor JF2 abgeschnürt bleibt, obwohl der zweite Transistor JF3 bereits im Durchbruch betrieben wird.

Um in einem Normalbetriebszustand die Leckströme der Schaltung zu verringern, können an die Steuereingänge E1, E2 zwei voneinander entkoppelte Ladungspumpen angeschlossen werden, welche jeweils eine Spannung erzeugen, welche der Summe aus Versorgungspotential VDD und der transistorabhängigen Abschnürspannung (Pinch-Off-Spannung) entspricht. Sollte einer der beiden abgeschnürten Transistoren JF2, JF3 durchbrechen, so verhindert die Entkopplung der Ladungspumpen wirksam, daß auch das Gate-Potential des jeweils anderen, noch abgeschnürt betriebenen Transistors sinkt.

An die Gates des ersten und zweiten Transistors JF2, JF3 sind jeweils Widerstände R7, R8 bzw. R9 angeschlossen, an denen jeweils eine Ladungspumpe anschließbar ist. Diese Widerstände bilden mit parasitären Gate-Drain-Kapazitäten des ersten und zweiten Transistors JF2, JF3 jeweils einen Tiefpaß, welcher eine Überkopplung von an den Ladungspumpen entstehenden Rippeln auf den Ausgang OUT wirksam verhindert. Um die Strombelastung der Ladungspumpen so gering als möglich zu halten, werden lediglich zwei der vier JFET-Transistoren, nämlich der erste und der zweite Transistor JF2, JF3 gepumpt betrieben, derart, daß das Gate-Potential des ersten und zweiten Transistors im Normalbetrieb größer als das Versorgungspotential plus die Abschnürspannung der Transistoren beträgt.

Zur weiteren Vermeidung von Degeneration am vierten Transistor JF4 durch zu große Spannungsbelastung ist ein Widerstand R12 zwischen Gate des vierten Transistors und Bezugspotential geschaltet, welcher gemeinsam mit dem sechsten Widerstand eine Spannungsteilung des Potentials am Ausgang OUT vornimmt.

Weiterhin sind Kondensatoren C1, C2 zwischen Source-Anschluß des ersten Transistors JF2 und Steuereingang des ersten bzw. zweiten Transistors JF2, JF3 geschaltet. Diese dienen zum einen der Glättung des Entladerippels bei an den Steuereingängen E1, E2 angeschlossenen Ladungspumpen, zum anderen liegen die Kapazitäten nicht direkt am Bezugspotential, so daß sie über ersten Widerstand R1 und dritten Transistor JF1 vor elektrostatischen Entladungen und vor durch elektromagnetische Einkopplungen verursachten Pulsen geschützt sind. Dabei ist zu beachten, daß die Zeitkonstante, welche sich aus dem Produkt aus erstem Widerstand und Drain-Source-Widerstand des dritten Transistors JF1 sowie der Summe aus Kapazitätswerten von erster und zweiter Kapazität C1, C2 ergibt, hinreichend klein gegenüber einer Taktperiode der Ladungspumpen-Frequenz sind.

Am Ausgang OUT der Schaltung ist ein dritter Kondensator C3 gegen Masse geschaltet, welcher zur weiteren Glättung des am Ausgang OUT anliegenden Signals dient und einen Kapazitätswert von 100 pF hat.

Die Schaltungsanordnung gemäß Figur 4 kann über Versorgungsleitungen an elektrische Lasten angeschlossen werden, welche entweder zwischen Ausgang OUT und Versorgungspotential VDD oder Ausgang OUT und Bezugspotential GND schaltbar sind. Dabei erkennt die Schaltungsanordnung aufgrund der gebildeten nichtlinearen Kennlinie Unterbrechungen der Versorgungsleitungen und schaltet den Ausgang OUT auf die verbleibende, intakte Versorgungsleitung.

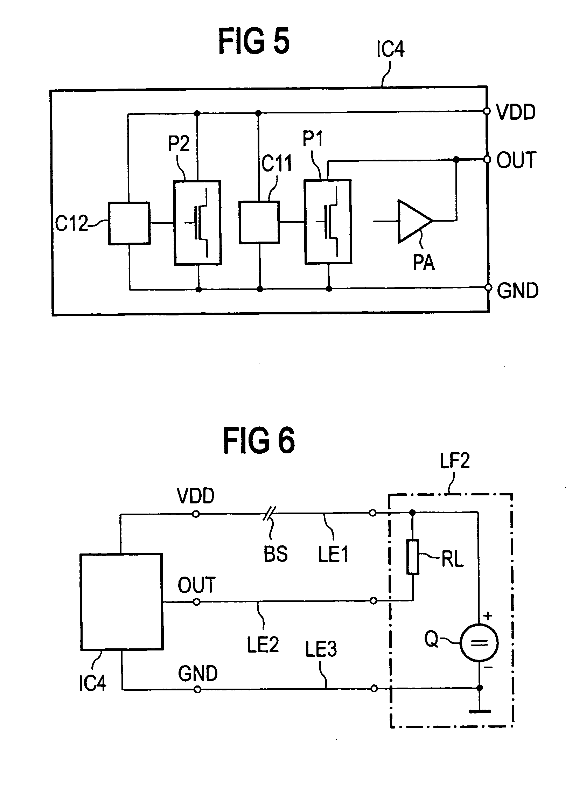

Figur 5 zeigt eine Ausführungsform einer Schaltungsanordnung zur Erkennung eines Fehlerzustands IC4 mit je einem Anschluß für ein Versorgungs- und Bezugspotential VDD, GND. Dabei ist ein erster selbstleitender Transistor P1, der lastseitig zwischen Ausgang OUT und Bezugspotential GND und ein zweiter selbstleitender Transistor P2, der lastseitig zwischen Bezugs- und Versorgungspotential GND, VDD angeschlossen ist, vorgesehen. Zur Ansteuerung der Transistoren P1, P2 ist jeweils ein Mittel zum Detektieren eines Fehlerzustands C11, C12 eingangsseitig mit Bezugs- und Versorgungspotential VDD, GND und ausgangsseitig mit je einem Steuereingang des ersten beziehungsweise zweiten Transistors P1, P2 verbunden. An den zweiten Schaltungsknoten OUT ist der Ausgang einer linearen Verstärkerstufe PA angeschlossen. In einem Normalbetriebszustand sind die Kanäle der selbstleitenden Transistoren P1, P2 abgeschnürt, während in einem Fehlerfall die Kanäle niederohmig sind. Hierzu wird in Abhängigkeit der durch Versorgungs- und Bezugspotential VDD, GND bereitgestellten Versorgungsspannung eine geeignete Steuerspannung in den Mitteln zum Detektieren eines Fehlerzustands C11, C12 erzeugt und an die Steuereingänge der Transistoren P1, P2 angelegt. Zum Bereitstellen der Abschnürspannungen für die Transistoren P1, P2 können Ladungspumpen vorgesehen sein, welche in einem Normalbetrieb jeweils eine Gatespannung erzeugen, welche außerhalb der Versorgungsspannung liegt.

Es ist kein selbstleitendes Bauteil zwischen als Ausgang OUT ausgeführtem zweiten Bezugsknoten und dem Anschluß für das Versorgungspotential VDD vorgesehen. Hierdurch ergibt sich beim Einschalten der Schaltungsanordnung ein monotones Einschaltverhalten bezüglich des Potentials am Ausgang OUT der Ausgangsstufe PA. Es ist kein Spannungsteiler aus Transistoren wie in Figuren 3, 4 gebildet, der zu einem nichtmonotonen Einschaltverhalten bezüglich der Spannung am Ausgang OUT führen kann.

Das Ausführungsbeispiel gemäß Figur 5 weist ein verbessertes Überspannungsverhalten auf, da der Anschluß für das Versorgungspotential VDD vom Ausgang OUT entkoppelt ist. Bei Auftreten hoher Spannungen am Ausgang OUT, welche höher als die Versorgungsspannung sind, entsteht kein beträchtlicher Stromfluß vom Ausgang OUT zum Anschluß für das Versorgungspotential VDD. Bei einem Durchbruch des Transistors P1 fließt lediglich ein Strom vom Ausgang OUT nach Masse, ohne die Spannungsquelle Q zu belasten. Bei Auftreten einer Überspannung am Versorgungspotential-Anschluß VDD hingegen beeinflußt der vom Versorgungs- zum Bezugspotential über Transistor P2 fließende Strom vorteilhafterweise nicht das Potential am Ausgang OUT, so daß die Ausgangsstufe PA mit geringer Treiberfähigkeit ausgelegt werden kann und dennoch das Potential am Ausgang OUT auf Bezugspotential GND gehalten werden kann.

Figur 6 zeigt eine Anwendung der Schaltungsanordnung von Figur 5 auf einen zweiten Lastfall LF2, bei dem ein als Pull-Up-Last geschalteter Lastwiderstand RL über je eine lange Leitung LE1, LE2 an Versorgungspotential-Anschluß VDD und Ausgang OUT der Schaltungsanordnung IC4 angeschlossen ist. Eine externe Spannungsquelle Q ist über die lange Leitung LE1 an den Anschluß für das Versorgungspotential VDD und über eine lange Leitung LE3 an den Anschluß für das Bezugspotential GND angeschlossen.

Falls eine Bruchstelle BS auf einer der die Versorgungsspannung führenden Leitungen LE1, LE3 auftritt, so stellt die Schaltungsanordnung am Ausgang OUT ein Potential ein, welches dem der verbleibenden, intakten Leitung entspricht. Im Falle des Bruchs der Leitung LE1 ist über den Transistor P1 eine niederohmige Verbindung zwischen Ausgang OUT Anschluß für das Bezugspotential GND hergestellt. Selbst bei Vorsehen eines Pull-Up-Lastwiderstands RL, der normalerweise das Potential am Ausgang OUT auf Versorgungspotential VDD zieht, bleibt der Ausgang OUT potentialmäßig nahezu, wie gewünscht, auf Bezugspotential GND, da der Widerstand des niederohmigen Transistors P1 von ca. 100 Ohm klein gegenüber dem Lastwiderstand RL ist, welcher ca. 10 kOhm beträgt. Im Falle des Bruchs der Leitung LE3 ist über die Serienschaltung aus Transistor P1 und Transistor P2 eine niederohmige Verbindung zwischen Ausgang OUT und Anschluß für Versorgungspotential VDD hergestellt.

Wenn zur Bereitstellung der Abschnürspannung Ladungspumpen vorgesehen sind, welche üblicherweise getaktet betrieben werden, so verringert die beschriebene Ausführung der Schaltungsanordnung den am Ausgang OUT wegen parasitärer Kapazitäten der Transistoren P1, P2 auftretenden Störspannungsrippel, da lediglich ein Transistor P1, nicht zwei, unmittelbar am Ausgang OUT angeschlossen ist.

## Patentansprüche

1. Schaltungsanordnung (IC1, IC2, IC3, IC4) zur Erkennung eines Fehlerzustands, mit
- drei Anschlüssen, umfassend einen ersten Schaltungsknoten (OUT), an den eine elektrische Last (RL) anschließbar ist, einen Anschluß für ein Versorgungspotential (VDD) und einen Anschluß für ein Bezugspotential (GND), welche an eine Spannungsquelle (Q) anschließbar sind,
- einer signalverarbeitenden Schaltung (PA), deren Ausgang an den ersten Schaltungsknoten angeschlossen ist,
- einem ersten Transistor (S1, JF2, P1), der von einem selbstleitenden Typ ist,
- der einen ersten Lastanschluß hat, welcher mit dem ersten Schaltungsknoten (OUT) verbunden ist,
- der einen zweiten Lastanschluß hat, welcher mit dem Anschluß für Versorgungspotential (VDD) oder Bezugspotential (GND) verbunden ist,
**dadurch gekennzeichnet, dass**
- die Schaltungsanordnung ausgebildet ist zur Zuführung einer den Kanal des ersten Transistors (S1, JF2, P1) abschnürende Spannung an einem Steuereingang (E1) des ersten Transistors (S1, JF2, P1) in einem Normalbetriebszustand und zu einer niederohmigen Verbindung des ersten und des zweiten Lastanschlusses des Transistors (S1, JF2, P1) über dessen Kanal in einem Fehlerzustand.

2. Schaltungsanordnung nach Anspruch 1,
**dadurch gekennzeichnet, daß**
der Fehlerzustand dann gegeben ist, wenn eine an die Schaltungsanordnung (IC1, IC2, IC3, IC4) angeschlossene Versorgungsleitung (VL1, VL2), welche eine Spannungsquelle (Q) mit dem Anschluß für Versorgungs- oder Bezugspotential (VDD, GND) verbindet, unterbrochen ist oder eine unter einer minimalen Spannungsgrenze liegende Spannung aufweist.

3. Schaltungsanordnung nach Anspruch 1 oder 2,
**dadurch gekennzeichnet, daß**
die signalverarbeitende Schaltung (PA) eine lineare Ausgangsstufe ist.

4. Schaltungsanordnung nach einem der Ansprüche 1 bis 3,
**dadurch gekennzeichnet, daß**
der zweite Lastanschluß mit dem Anschluß für das Versorgungspotential (VDD) verbunden ist und eine elektrische Last (RL) in einem ersten Lastfall (LF1) einerseits an den ersten Schaltungsknoten (OUT) und andererseits an den Anschluß für das Bezugspotential (GND) angeschlossen ist.

5. Schaltungsanordnung nach Anspruch 4,
**dadurch gekennzeichnet, daß**
ein zweiter Transistor (S2, JF3) vorgesehen ist, der einen ersten Lastanschluß hat, welcher an den Anschluß für das Bezugspotential (GND) angeschlossen ist und der einen zweiten Lastanschluß hat, welcher mit dem ersten Schaltungsknoten (OUT) verbunden ist, wobei in einem Normalbetrieb am Steuereingang (E2) des zweiten Transistors (S2, JF3) eine dessen Kanal abschnürende Spannung anliegt.

6. Schaltungsanordnung nach Anspruch 5,
**dadurch gekennzeichnet, daß**
der erste und der zweite Transistor (JF2, JF3) P-Kanal-JFET sind.

7. Schaltungsanordnung nach Anspruch 5,
**dadurch gekennzeichnet, daß**
der erste und der zweite Transistor (JF2, JF3) N-Kanal-JFET sind.

8. Schaltungsanordnung nach einem der Ansprüche 5 bis 7,
**dadurch gekennzeichnet, daß**
ein dritter Transistor (JF1) vorgesehen ist, der lastseitig einerseits an den Anschluß für das Versorgungspotential (VDD) und andererseits an den ersten Transistor (JF2) angeschlossen ist, und daß ein vierter Transistor (JF4) vorgesehen ist, der lastseitig einerseits an den zweiten Transistor (JF3) und andererseits an den Anschluß für das Bezugspotential (GND) angeschlossen ist.

9. Schaltungsanordnung nach Anspruch 8,
**dadurch gekennzeichnet, daß**
eine Teilschaltung (TS) zur Begrenzung der Verlustleistung vorgesehen ist, welche an Steuereingänge der ersten bis vierten Transistoren (JF1, JF2, JF3, JF4) angeschlossen ist.

10. Schaltungsanordnung nach Anspruch 9,
**dadurch gekennzeichnet, daß**
- ein erster Widerstand (R1) zwischen Versorgungspotential (VDD) und einem Lastanschluß des dritten Transistors (JF1) angeschlossen ist,
- ein zweiter Widerstand (R2) zwischen erstem Schaltungsknoten (OUT) und erstem Lastanschluß des ersten Transistors (JF2) und
- ein dritter Widerstand (R3) zwischen erstem Schaltungsknoten (OUT) und zweitem Lastanschluß des zweiten Transistors (JF3) angeschlossen ist,
- ein vierter Widerstand (R4) parallel zu einer ersten Diode (D1) zwischen Versorgungspotential (VDD) und einem Steuereingang des dritten Transistors (JF1) angeschlossen ist, an dem eine zweite. Diode (D2) seriell zu einem fünften Widerstand (R5) gegen den ersten Schaltungsknoten (OUT) geschaltet ist,
- ein sechster Widerstand (R6) einerseits an den ersten Schaltungsknoten (OUT) und andererseits an den Steuereingang des vierten Transistors (JF4) angeschlossen ist,
- eine dritte Diode (D3) und eine vierte Diode (D4) einerseits an den ersten Schaltungsknoten (OUT) und andererseits an je einen Steuereingang des ersten bzw. zweiten Transistors (JF2, JF3) angeschlossen sind, und
- eine fünfte Diode einerseits mit dem Versorgungspotential (VDD) und andererseits mit einem siebten Widerstand verbunden ist, welcher am den Steuereingang des ersten Transistors (JF2) angeschlossen ist.

11. Schaltungsanordnung nach einem der Ansprüche 8 bis 10,
**dadurch gekennzeichnet, daß**
Gate-Entladewiderstände (R10, R11) vorgesehen sind, von denen ein erster Gate-Entladewiderstand (R10) einerseits an den Steueranschluß des ersten und andererseits an den Steueranschluß des zweiten Transistors (JF2, JF3) angeschlossen ist und ein zweiter Gate-Entladewiderstand (R11) einerseits an den Steuereingang des ersten Transistors (E1) und andererseits an das Versorgungspotential (VDD) angeschlossen ist.

12. Schaltungsanordnung nach einem der Ansprüche 8 bis 11,
**dadurch gekennzeichnet, daß**
Glättungskondensatoren (C1, C2) vorgesehen sind, von denen ein erster (C1) zwischen zweitem Lastanschluß des ersten Transistors (JF2) und Steuereingang des ersten Transistors (E1) und ein zweiter (C2) zwischen Steuereingang (E2) des zweiten Transistors (JF3) und zweitem Lastanschluß des ersten Transistors (JF2) angeschlossen ist.

13. Schaltungsanordnung nach einem der Ansprüche 1 bis 3,
**dadurch gekennzeichnet, daß**
ein zweiter Transistor (P2) vorgesehen ist, der einen ersten Lastanschluß hat, welcher an den Anschluß für das Bezugspotential (GND) angeschlossen ist, und der einen zweiten Lastanschluß hat, welcher an den Anschluß für das Versorgungspotential (VDD) angeschlossen ist.

14. Schaltungsanordnung nach einem der Ansprüche 1 bis 13,
**dadurch gekennzeichnet, daß**
ein Mittel zum Detektieren des Fehlerzustands (C11) vorgesehen ist, welches eingangsseitig mit den Anschlüssen für Versorgungs- und Bezugspotential (VDD, GND) und ausgangsseitig mit dem ersten Transistor (P1) verbunden ist.

## Claims

1. Circuit arrangement (IC1, IC2, IC3, IC4) for identifying a fault state, having
- three terminals, comprising a first circuit node (OUT), to which an electrical load (RL) can be connected, a terminal for a supply potential (VDD) and a terminal for a reference potential (GND), which can be connected to a voltage source (Q),
- a signal-processing circuit (PA), whose output is connected to the first circuit node,
- a first transistor (S1, JF2, P1), which is of a normally on type,
- which has a first load terminal connected to the first circuit node (OUT),
- which has a second load terminal connected to the terminal for supply potential (VDD) or reference potential (GND),
**characterized in that**
- the circuit arrangement is designed to supply a voltage which pinches off the channel of the first transistor (S1, JF2, P1) at a control input (E1) of the first transistor (S1, JF2, P1) in a normal operating state and to produce a low-impedance connection of the first and second load terminals of the transistor (S1, JF2, P1) via the channel of said transistor in a fault state.

2. Circuit arrangement according to Claim 1,
**characterized in that**
the fault state exists when a supply line (VL1, VL2), which is connected to the circuit arrangement (IC1, IC2, IC3, IC4) and connects a voltage source (Q) to the terminal for supply or reference potential (VDD, GND), is interrupted or has a voltage below a minimum voltage limit.

3. Circuit arrangement according to Claim 1 or 2,
**characterized in that**
the signal-processing circuit (PA) is a linear output stage.

4. Circuit arrangement according to one of Claims 1 to 3,
**characterized in that**
the second load terminal is connected to the terminal for the supply potential (VDD) and an electrical load (RL), in a first load case (LF1) is connected on the one hand to the first circuit node (OUT) and on the other hand to the terminal for the reference potential (GND).

5. Circuit arrangement according to Claim 4,
**characterized in that**
a second transistor (S2, JF3) is provided, which has a first load terminal connected to the terminal for the reference potential (GND) and which has a second load terminal connected to the first circuit node (OUT), a voltage which pinches off the channel of the second transistor (S2, JF3) being present at the control input (E2) of said second transistor in normal operation.

6. Circuit arrangement according to Claim 5,
**characterized in that**
the first and second transistors (JF2, JF3) are P-channel JFETs.

7. Circuit arrangement according to Claim 5,
**characterized in that**
the first and second transistors (JF2, JF3) are N-channel JFETs.

8. Circuit arrangement according to one of Claims 5 to 7,
**characterized in that**
a third transistor (JF1) is provided, which, on the load side, is connected on the one hand to the terminal for the supply potential (VDD) and on the other hand to the first transistor (JF2), and **in that** a fourth transistor (JF4) is provided, which, on the load side, is connected on the one hand to the second transistor (JF3) and on the other hand to the terminal for the reference potential (GND).

9. Circuit arrangement according to Claim 8,
**characterized in that**
a subcircuit (TS) for limiting the power loss is provided, which is connected to control inputs of the first to fourth transistors (JF1, JF2, JF3, JF4).

10. Circuit arrangement according to Claim 9,
**characterized in that**
- a first resistor (R1) is connected between supply potential (VDD) and a load terminal of the third transistor (JF1),
- a second resistor (R2) is connected between first circuit node (OUT) and first load terminal of the first transistor (JF2), and
- a third resistor (R3) is connected between first circuit node (OUT) and second load terminal of the second transistor (JF3),
- a fourth resistor (R4) is connected in parallel with a first diode (D1) between supply potential (VDD) and a control input of the third transistor (JF1), at which a second diode (D2) is connected in series with a fifth resistor (R5) with respect to the first circuit node (OUT),
- a sixth resistor (R6) is connected on the one hand to the first circuit node (OUT) and on the other hand to the control input of the fourth transistor (JF4),
- a third diode (D3) and a fourth diode (D4) are connected on the one hand to the first circuit node (OUT) and on the other hand to a respective control input of the first and second transistor (JF2, JF3), and
- a fifth diode is connected on the one hand to the supply potential (VDD) and on the other hand to a seventh resistor connected to the control input of the first transistor (JF2).

11. Circuit arrangement according to one of Claims 8 to 10,
**characterized in that**
gate discharge resistors (R10, R11) are provided, of which a first gate discharge resistor (R10) is connected on the one hand to the control terminal of the first and on the other hand to the control terminal of the second transistor (JF2, JF3) and a second gate discharge resistor (R11) is connected on the one hand to the control input of the first transistor (E1) and on the other hand to the supply potential (VDD).

12. Circuit arrangement according to one of Claims 8 to 11,
**characterized in that**
smoothing capacitors (C1, C2) are provided, of which a first (C1) is connected between second load terminal of the first transistor (JF2) and control input of the first transistor (E1) and a second (C2) is connected between control input (E2) of the second transistor (JF3) and second load terminal of the first transistor (JF2).

13. Circuit arrangement according to one of Claims 1 to 3,
**characterized in that**
a second transistor (P2) is provided, which has a first load terminal connected to the terminal for the reference potential (GND) and which has a second load terminal connected to the terminal for the supply potential (VDD).

14. Circuit arrangement according to one of Claims 1 to 13,
**characterized in that**
a means for detecting the fault state (C1) is provided, which is connected to the terminals for supply and reference potential (VDD), GND) on the input side and to the first transistor (P1) on the output side.

## Revendications

1. Montage (IC1, IC2, IC3, IC4) de détection d'un état d'erreur, comprenant
- trois bornes comprenant un premier noeud (OUT) de circuit, auquel peut être raccordée une charge (RL) électrique, une borne pour un potentiel (VDD) d'alimentation et une borne pour un potentiel (GND) de référence, qui peuvent être raccordées à une source (Q) de tension,
- un circuit (PA) de traitement du signal, dont la sortie est raccordée au premier noeud de circuit,
- un premier transistor (S1, JF2, P1) qui est du type à mode de déplétion,
- une première borne de charge qui est reliée au premier noeud (OUT) de circuit,
- qui a une deuxième borne de charge qui est reliée à la borne pour le potentiel (VDD) d'alimentation ou pour le potentiel (GND) de référence,
**caractérisé en ce que**
- le montage est constitué pour appliquer une tension de resserrement du canal du premier transistor (S1, JF2, P1) sur une entrée (E1) de commande du premier transistor (S1, JF2, P1) dans un état de fonctionnement normal et à une liaison à petite valeur ohmique de la première et de la deuxième borne de charge du transistor (S1, JF2, P1) par son canal dans un état d'erreur.

2. Montage suivant la revendication 1,
**caractérisé en ce que** l'état d'erreur est donné lorsqu'une ligne (VL1, VL2) d'alimentation raccordée au montage (IC1, IC2, IC3, IC4) et reliant une source (Q) de tension à la borne pour le potentiel (VDD, GND) d'alimentation ou de référence est interrompue ou a une tension se trouvant en dessous d'une limite minimum de tension.

3. Montage suivant la revendication 1 ou 2,
**caractérisé en ce que** le circuit (PA) de traitement du signal est un étage de sortie linéaire.

4. Montage suivant l'une des revendications 1 à 3,
**caractérisé en ce que** la deuxième borne de charge est reliée à la borne pour le potentiel (VDD) d'alimentation et une charge (RL) électrique est raccordée dans un premier cas (LF1) de charge, d'une part, au premier noeud (OUT) de circuit et, d'autre part, à la borne pour le potentiel (GND) de référence.

5. Montage suivant la revendication 4,
**caractérisé en ce qu'**il est prévu un deuxième transistor (S2, JF3) qui a une première borne de charge raccordée à la borne pour le potentiel (GND) de référence et qui a une deuxième borne de charge reliée au premier noeud (OUT) de circuit dans lequel, dans un fonctionnement normal, il s'applique à l'entrée (E2) de commande du deuxième transistor (S2, JF3) une tension resserrant son canal.

6. Montage suivant la revendication 5,
**caractérisé en ce que** le premier et le deuxième transistor (JF2, JF3) sont des JFET à canal P.

7. Montage suivant la revendication 5,
**caractérisé en ce que** le premier et le deuxième transistor (JF2, JF3) sont des JFET à canal N.

8. Montage suivant l'une des revendications 5 à 7,
**caractérisé en ce qu'**il est prévu un troisième transistor (JF1) qui est raccordé côté charge, d'une part, à la borne pour le potentiel (VDD) d'alimentation et, d'autre part, au premier transistor (JF2), et **en ce qu'**il est prévu un quatrième transistor (JF4) qui est raccordé côté charge, d'une part, au deuxième transistor (JF3) et, d'autre part, à la borne pour le potentiel (GND) de référence.

9. Montage suivant la revendication 8,
**caractérisé en ce qu'**il est prévu un sous-circuit (TS) de limitation de la dissipation, qui est raccordé à des entrées de commande des premier à quatrième transistors (JF1, JF2, JF3, JF4).

10. Montage suivant la revendication 9,
**caractérisé en ce que**
- une première résistance (R1) est montée entre le potentiel (VDD) d'alimentation et une borne de charge du troisième transistor (JF1),
- une deuxième résistance (R2) est montée entre le premier noeud (OUT) de circuit et la première borne de charge du premier transistor (JF2) et
- une troisième résistance (R3) est montée entre le premier noeud (OUT) de circuit et la deuxième borne de charge du deuxième transistor (JF3),
- une quatrième résistance (R4) est montée en parallèle à une première diode (D1) entre le potentiel (VDD) d'alimentation et une entrée de commande du troisième transistor (JF1) sur lequel est montée une deuxième diode (D2) en série avec une cinquième résistance (R5) vers le premier noeud (OUT) de circuit,
- une sixième résistance (R6) est raccordée, d'une part, au premier noeud (OUT) de circuit et, d'autre part, à l'entrée de commande du quatrième transistor (JF4),
- une troisième diode (D3) et une quatrième diode (D4) sont raccordées, d'une part, au premier noeud (OUT) de circuit et, d'autre part, à respectivement une entrée de commande du premier et du deuxième transistor (JF2, JF3), et
- une cinquième diode est reliée, d'une part, au potentiel (VDD) d'alimentation et, d'autre part, à une septième résistance qui est raccordée à l'entrée de commande du premier transistor (JF2).

11. Montage suivant l'une des revendications 8 à 10,
**caractérisé en ce qu'**il est prévu des résistances (R10, R11) de décharge-grille, parmi lesquelles une première résistance (R10) de décharge-grille est raccordée, d'une part, à la borne de commande du premier transistor (JF2) et, d'autre part, à la borne de commande du deuxième transistor (JF3) et une deuxième résistance (R11) de décharge-grille est raccordée, d'une part, à la borne de commande du premier transistor (E1) et, d'autre part, au potentiel (VDD) d'alimentation.

12. Montage suivant l'une des revendications 8 à 11,
**caractérisé en ce qu'**il est prévu des condensateurs (C1, C2) de lissage, dont un premier (C1) est monté entre une deuxième borne de charge du premier transistor (JF2) et une entrée de commande du premier transistor (E1), et un deuxième (C2) entre l'entrée (E2) de commande du deuxième transistor (JF3) et une deuxième borne de charge du premier transistor (JF2).

13. Montage suivant l'une des revendications 1 à 3,
**caractérisé en ce qu'**il est prévu un deuxième transistor (P2) qui a une première borne de charge raccordée à la borne pour le potentiel (GND) de référence et qui a une deuxième borne de charge raccordée à la borne pour le potentiel (VDD) d'alimentation.

14. Montage suivant l'une des revendications 1 à 13,
**caractérisé en ce qu'**il est prévu un moyen de détection de l'état (C11) de défaut qui est relié, du côté entrée, aux bornes pour le potentiel (VDD) d'alimentation et le potentiel (GND) de référence et, du côté sortie, au premier transistor (P1).
